# EUROPEAN PATENT APPLICATION

(11) **EP 3 540 094 A1**
(43) Date of publication of application: **18.09.2019**
(21) Application number: 18197047.6
(22) Date of filing: 27.09.2018
(51) Int. Cl.: C23C 18/06, C23C 18/12, H01L 21/02, H01L 31/0749

(54) **COMPOSITE MATERIAL, CHEMICAL BATH DEPOSITION METHOD AND METHOD FOR MANUFACTURING CIGS PHOTOVOLTAIC MODULE**

(30) Priority: 14.03.2018 CN 201810209148
(71) Applicant: Beijing Apollo Ding Rong Solar Technology Co., Ltd., Beijing 100176 (CN)
(72) Inventor: Wang, Lei, Beijing, Beijing 100176 (CN); Guo, Lida, Beijing, Beijing 100174 (CN); Yang, Lihong, Beijing, Beijing 100174 (CN)
(74) Representative: Cohausz & Florack

(57) **Abstract**

Provided is a chemical bath deposition process, comprising the following steps: forming a first functional layer on one side of a substrate, and forming a composite material layer including a polymeric hydrogel and magnetic nanoparticles mixed in the polymeric hydrogel on the opposite side of the substrate; putting the substrate on which the first functional layer and the composite material layer have been formed, into a deposition solution to deposit a second functional layer on the first functional layer; and separating the composite material layer from the substrate.

## Description

### Cross-Reference to Related Applications

The present application claims the priority of Chinese Application No. 201810209148.4, filed before Chinese Patent Office on March 14, 2018, and entitled "CHEMICAL BATH DEPOSITION METHOD AND METHOD FOR MANUFACTURING CIGS PHOTOVOLTAIC MODULE", the entire contents of which are herein incorporated by reference.

### Technical Field

The present disclosure relates to the field of thin film power generation technology, and particularly to a chemical bath deposition method and a method for manufacturing a CIGS photovoltaic module, and a composite material used in the two methods.

### Background

Chemical bath deposition (CBD) has attracted great attention because of its advantages such as low film forming temperature, suitability for manufacturing large-area films, easy realization of continuous production, no pollution and low material consumption. For example, in manufacturing of a CIGS (copper (Cu), indium(In), gallium(Ga), selenide(Se)) thin film solar cell with high conversion efficiency, a cadmium sulfide (CdS) semiconductor thin film buffer layer is usually prepared by a chemical bath deposition method.

### Summary

In one aspect, provided is a chemical bath deposition method, including the following steps:
forming a first functional layer on one side of a substrate, and forming a composite material layer including a polymeric hydrogel and magnetic nanoparticles mixed in the polymeric hydrogel on the opposite side of the substrate;
putting the substrate on which the first functional layer and the composite material layer have been formed, into a deposition solution to deposit a second functional layer on the first functional layer; and
separating the composite material layer from the substrate.

In some embodiments of the present disclosure, the first functional layer includes a p-junction material layer.

In some embodiments of the present disclosure, the first functional layer further includes a light-emitting layer, and the P-junction material layer and the light-emitting layer are disposed separately so as to make them insulative with each other.

In some embodiments of the present disclosure, the second functional layer includes a n-junction material layer.

In some embodiments of the present disclosure, the polymeric hydrogel accounts for 80% to 95% by mass and the magnetic nanoparticles account for 5% to 20%by mass, based on the composite material layer.

In some embodiments of the present disclosure, the polymeric hydrogel is selected from at least one of the group consisting of cross-linked copolymer of polyacrylic resin, polyvinyl alcohol, polyacrylamide and silicon-based hydrogel.

In some embodiments of the present disclosure, the magnetic nanoparticles are Fe₃O₄.

In some embodiments of the present disclosure, the substrate is inductively heated with an alternating magnetic field during depositing of the second functional layer.

In some embodiments of the present disclosure, the alternating magnetic field has a frequency of 450 kHz to 550 kHz.

In some embodiments of the present disclosure, the composite material layer is dissolved with a solvent to make the composite material layer separate from the substrate.

In some embodiments of the present disclosure, the solvent is selected from at least one of the group consisting of dimethyl sulfoxide and N-dimethyl formamide. In some embodiments of the present disclosure, the composite material layer is formed on the opposite side of the substrate by screen printing.

In another aspect, some embodiments of the present disclosure further provide a method for manufacturing a CIGS photovoltaic module, including the following steps:
forming a CIGS layer on one side of a substrate, and forming a composite material layer including a polymeric hydrogel and magnetic nanoparticles mixed in the polymeric hydrogel on the opposite side of the substrate;
putting the substrate on which the CIGS layer and the composite material layer have been formed, into a deposition solution to deposit a CdS layer on the CIGS layer; and separating the composite material layer from the substrate.

In some embodiments of the present disclosure, the polymeric hydrogel accounts for 80% to 95% by mass and the magnetic nanoparticles account for 5% to 20%by mass, based on the composite material layer.

In some embodiments of the present disclosure, the substrate is inductively heated with an alternating magnetic field during depositing of the CdS layer.

In still another aspect, some embodiments of the present disclosure provide a composite material including a polymeric hydrogel and magnetic nanoparticles mixed in the polymeric hydrogel.

In some embodiments of the present disclosure, the polymeric hydrogel accounts for 80% to 95% by mass and the magnetic nanoparticles account for 5% to 20%by mass, based on the composite material layer.

In some embodiments of the present disclosure, the polymeric hydrogel is selected from at least one of the group consisting of cross-linked copolymer of polyacrylic resin, polyvinyl alcohol, polyacrylamide and silicon-based hydrogel.

In some embodiments of the present disclosure, the magnetic nanoparticles are Fe₃O₄.

### Brief Description of the Drawings

Fig. 1 is a flow diagram of a chemical bath deposition method according to some embodiments of the present disclosure;
Fig. 2 is a schematic diagram of a method for manufacturing a CIGS photovoltaic module according to some embodiments of the present disclosure;
Fig. 3 is another schematic diagram of a method for manufacturing a CIGS photovoltaic module according to some embodiments of the present disclosure.

### Detailed Description of the Embodiments

The composite material and the method for manufacturing a cadmium sulfide thin film with CBD process according to the present disclosure will be further described below in combination with the embodiments and the accompanying drawings.

CBD process for manufacturing a cadmium sulfide (CdS) semiconductor thin film mainly includes a rocking CBD process and an immersing CBD process. The rocking CBD process has a significantly higher coating uniformity than the immersing CBD process, which mainly benefits from higher temperature uniformity of the rocking CBD process. When CdS is deposited with the rocking CBD process, the glass substrate is heated first, while the chemical reaction solution is added into the reaction chamber at a room temperature. Therefore, in the rocking CBD process, CdS is first deposited on the surface of the glass substrate, which greatly reduces the concentration of random CdS particles formed in the chemical reaction solution.

However, in the immersing CBD process, the pre-mixture (containing no thiourea) of the chemical reaction solution is first heated to a reaction temperature, then the thiourea is added in. After the pre-mixture and the thiourea are stirred uniformly, the cold glass substrate is fed into the reaction chamber to start CdS deposition. Therefore, the main problem of the immersing CBD process lies in that, before the glass substrate is fed, CdS particles have been generated in the chemical reaction solution and are suspended in the chemical reaction solution, which has a negative impact on the coating process. The glass substrate which is not preheated is slowly heated by the chemical reaction solution and the deposition rate of CdS is lower at the initial stage, which results in lower utilization rate of the chemical reaction solution. In addition, in the immersing CBD process, CdS is deposited on both the front and back sides of the glass substrate, wherein only the CdS film layer on the front side is an effective film layer of the module, and the CdS film layer on the back side has to be cleaned. Moreover, the design of a back cleaning machine also encounters many technical challenges, which has become a bottleneck of industrialization of the immersing CBD process.

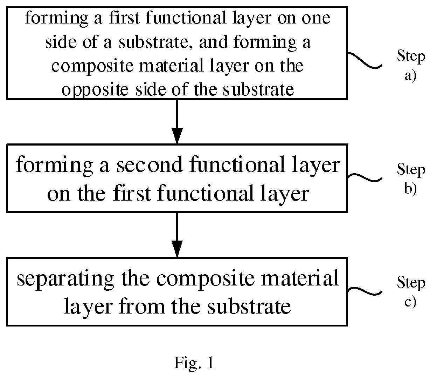

As shown in Fig. 1, some embodiments of the present disclosure provide a chemical bath deposition process, the process including the following steps:
a) forming a first functional layer on one side of a substrate, and forming a composite material layer including a polymeric hydrogel and magnetic nanoparticles mixed in the polymeric hydrogel on the opposite side of the substrate;
b) putting the substrate on which the first functional layer and the composite material layer have been formed, into a deposition solution to deposit a second functional layer on the first functional layer; and
c) separating the composite material layer from the substrate.

According to the chemical bath deposition method, the composite material layer is formed on the opposite side of the substrate as a protective layer, so that the opposite side of the substrate having the composite material layer does not contact with the deposition solution. Meanwhile, the swelling of the polymeric hydrogel of the composite material layer in the deposition solution reduces the circulation rate of the deposition solution around the opposite side of the substrate, thereby avoiding ineffective deposition of the second functional layer on the composite material layer (because the deposition solution does not need to be deposited on the composite material layer, and even if deposited, it further needs to be removed by a subsequent process). Therefore, the utilization rate of the deposition solution is improved, thereby saving the materials for reaction and reducing the cost. Moreover, the removal of the composite material layer is facilitated, thereby reducing the cleaning difficulty. It should be noted that, the material of the substrate in step a) is not limited. For example, it may be a glass substrate or a metal substrate.

In some embodiments, the first functional layer formed in step a) includes a p-junction material layer. The p-junction material layer is a light absorption layer of the photovoltaic module, and the p-junction material layer includes, but not limited to, any one or more of a copper indium gallium selenide (CIGS) layer, a single crystal silicon layer, a polysilicon layer, a gallium arsenide layer, and an organic dye layer. In some embodiments of the present disclosure, the first functional layer further includes a light-emitting layer, and the P-junction material layer and the light-emitting layer are disposed separately so as to make them insulative with each other. The light-emitting layer is a functional layer of an Organic Light-Emitting Diode (OLED), and the light-emitting layer includes, but not limited to, an organic light-emitting semiconductor material layer.

When the P-junction material layer and the light-emitting layer are both formed on the substrate in step a), a first mask may be used first and the P-junction material layer is formed at regions not covered by the first mask on the substrate; and then the P-junction material layer formed is covered by a second mask and the light-emitting layer is formed at regions not covered by the second mask on the substrate. The P-junction material layer and the light-emitting layer formed are disposed separately so as to make them insulative with each other. The P-junction material layer and the light-emitting layer may be arranged at intervals, or arranged adjacently in different regions. It will be two-way used if the P-junction material layer and the light-emitting layer are both formed on the substrate. During the daytime, the P-junction material layer may absorb sunlight to generate power, and store electric energy; and at night, the light-emitting layer may emit light with the stored electric energy, thereby decorating and embellishing a building curtain wall.

In step a), the composite material layer is formed on the opposite side of the substrate by screen printing. The composite material layer includes a polymeric hydrogel and magnetic nanoparticles mixed in the polymeric hydrogel, and thus has the characteristics of the two materials: being capable of inductive heating and also having film forming property and swelling property. The polymeric hydrogel as a carrier can be screen-printed. It is benefit to ensure the uniformity of the composite material layer that the composite material including a polymeric hydrogel and magnetic nanoparticles is coated on the opposite side of the substrate by screen printing.

In step a), the polymeric hydrogel accounts for 80% to 95% by mass and the magnetic nanoparticles account for 5% to 20%by mass, based on the composite material layer. The polymeric hydrogel is selected from at least one of the group consisting of cross-linked copolymer of polyacrylic resin, polyvinyl alcohol, polyacrylamide and silicon-based hydrogel. The magnetic nanoparticles are Fe₃O₄. The strength, swelling and other properties of the composite material layer can be adjusted by using different polymeric hydrogel materials, which is not limited in the present disclosure. In view of that cross-linked copolymer of polyacrylic resin has good film coating property, simple synthesis, low cost, as well as good water swelling property with a adjustable swelling ratio, the polymeric hydrogel is cross-linked copolymer of polyacrylic resin in some embodiments.

In some embodiments, the second functional layer in step b) includes a n-junction material layer. The n-junction material layer is a buffer layer of the photovoltaic module, and is matched with the p-junction material layer to form a p-n junction. When the p-n junction is irradiated by the sunlight, electrons and holes in the barrier region of the p-n junction move in opposite directions respectively and leave the barrier region. As a result, the potential of the p region increases, and the potential of the n region reduces, so that a voltage and a current can be generated in an external circuit connected to the p-n junction so as to convert the light energy into electrical energy. The common n-junction material layer is a CdS layer. The second functional layer is a functional layer capable of being used in conjunction with the first functional layer.

In step b), during depositing of the second functional layer, the substrate is inductively heated using an alternating magnetic field having a frequency in the range of 450 kHz to 550 kHz, and the heating temperature depends on the second functional layer to be deposited. For example, when the second functional layer to be deposited is a cadmium sulfide (CdS) layer, the heating temperature is 60°C to 70°C; and when the second functional layer to be deposited is a zinc sulfide (ZnS) layer, the heating temperature is 75°C to 80°C. The substrate is inductively heated through the alternating magnetic field such that the substrate is heated first, and then the deposition solution is heated by the substrate. By this way, it could be ensured that the temperature of the substrate is higher than the temperature of the deposition solution and the deposition is more likely to occur on the substrate, so that the generation of suspended particles in the deposition solution, due to the temperature of the deposition solution is higher than that of the substrate, is avoided. In some embodiments, the alternating magnetic field is generated by an alternating current, and the alternating magnetic field should be matched with the inductive heating function of the composite material layer. The inductive heating function of the composite material layer depends on the content of the magnetic nanoparticles, and the higher the content of the magnetic nanoparticles is, the better the inductive heating function of the composite material layer is. Therefore, a suitable inductive heating function for the composite material layer could be achieved by adjusting the mass percent of the magnetic nanoparticles and the polymeric hydrogel.

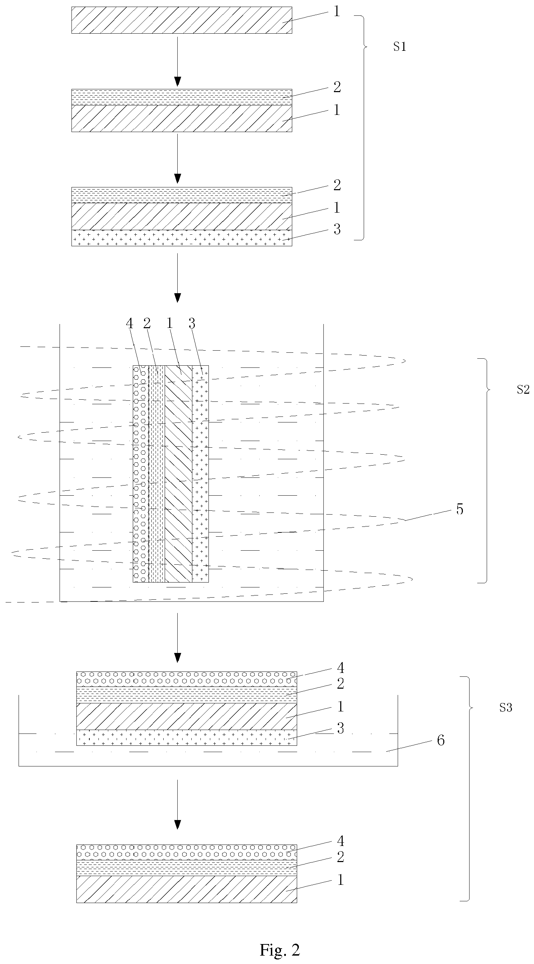

During depositing of the second functional layer in step b), the substrate is disposed in parallel with the side wall of a reaction container or tank containing the deposition solution, so that the circuit is arranged conveniently to make the alternating magnetic field substantially perpendicular to the substrate (for example, as shown in Fig. 2, the alternating magnetic field 5 shown by broken lines are substantially perpendicular to the substrate 1), thereby enhancing the inductive heating effect of the alternating magnetic field. The principle of electromagnetic inductive heating is to generate heat by magnetic field induction; for example, a high-speed varying high-frequency and high-voltage current flows through a coil to generate a high-speed varying alternating magnetic field, and when the magnetic force lines in the alternating magnetic field pass through a magnetic conductive metal material, numerous small eddy currents are generated in the magnetic conductive metal material so as to make the magnetic conductive metal material generate heat at a high speed by itself. Thus, in some embodiments of the present disclosure, the alternating magnetic field 5 makes the magnetic nanoparticles in the composite material layer to be rapidly heated.

In some embodiments, when the composite material layer is separated from the substrate in step c), the composite material layer is dissolved with a solvent. The solvent includes, but not limited to, at least one of dimethyl sulfoxide (DMSO) and N-dimethyl formamide (DMF). Both the DMSO and the DMF can dissolve the polymeric hydrogel. When the composite material layer is to be separated from the substrate, the composite material layer is immersed into the solvent and dissolved. After the solvent dissolves the polymeric hydrogel in the composite material layer, the magnetic nanoparticles in the composite material layer flow into the solvent at the same time, so that the composite material layer is effectively separated from the substrate. The above-mentioned wet process for removing the composite material layer from the substrate has low technical cost, does not cause damage to the substrate, and facilitates recycling of the magnetic nanoparticles as well.

The above chemical bath deposition method has the following advantages:
1. the composite material layer is formed on the opposite side of the substrate as a protective layer, so that the opposite side of the substrate does not contact with the deposition solution, thereby avoiding ineffective deposition of the second functional layer on the opposite side of the substrate;
2. the non-contact inductive heating of the magnetic nanoparticles in the composite material layer not only ensures the heating uniformity of the substrate, but also ensures the temperature of the substrate higher than that of the deposition solution, so that the deposition of the second functional layer is more ready to occur, and thus the deposition rate of the second functional layer on the first functional layer is improved;
3. the polymeric hydrogel in the composite material layer served as an effective carrier of the magnetic nanoparticles, which not only ensures uniform distribution of the magnetic nanoparticles, but also avoid the lost of the magnetic nanoparticles from the composite material;
4. the polymeric hydrogel swells in the deposition solution due to absorb the molecules of the deposition solution, and thereafter the absorbing rate of the polymeric hydrogel declines which results in a reduction of the circulation rate of the deposition solution on the opposite side of the substrate, thereby avoiding ineffective deposition of the second functional layer on the composite material layer and further facilitating the removal of the composite material layer;
5. the synthesis process of the composite material in the composite material layer is mature, so that the composite material can achieve mass production and is low in cost; and the added magnetic nanoparticles can be reused;
6. the separation of the composite material layer from the substrate not only is low in technical cost, but also does not cause damage to the substrate; and
7. the magnetic nanoparticles can be recycled.

Therefore, the above-mentioned chemical bath deposition process can effectively improve the immersing CBD process, solve the problem in heating uniformity of the substrate in the immersing CBD process, and improve the film forming efficiency and the film forming uniformity of the immersing CBD process. At the same time, it can ensure that the deposition of the second functional layer could start from the first functional layer of the substrate, and reduce the amount of the suspended particles rapidly generated in the deposition solution. In addition, it can also effectively avoid ineffective deposition of the second functional layer on the opposite side of the substrate, and eliminate the subsequent chemical cleaning process for the ineffective deposition of the second functional layer.

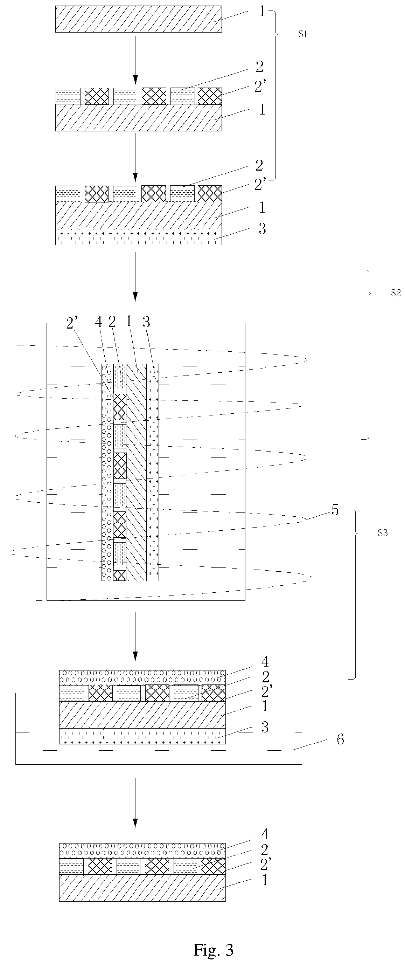

As shown in Figs. 2 and 3, some embodiments of the present disclosure further provide a method for manufacturing a CIGS photovoltaic module, including the following steps:
S1, forming a CIGS layer 2 on one side of a substrate 1 (or forming a CIGS layer 2, and a light-emitting layer 3 as shown in Fig. 3), and forming a composite material layer 3 including a polymeric hydrogel and magnetic nanoparticles mixed in the polymeric hydrogel on the opposite side of the substrate 1;
S2, putting the substrate 1 on which the CIGS layer 2 and the composite material layer 3 have been formed, into a deposition solution to deposit a CdS layer 4 on the CIGS layer 2; and
S3, separating the composite material layer 3 from the substrate 1.

In S1, the material of the substrate 1 is not limited, and common substrates of photovoltaic modules are feasible. For example, the substrate 1 is a glass substrate, and it may be other common substrates of photovoltaic modules can also be used according to specific applications.

In S2, the substrate 1 is heated inductively using an alternating magnetic field during the deposition, and the temperature of the inductive heating is 60°C to 70°C. The deposition solution includes a pre-mixture of cadmium sulfate, ammonia water and pure water, and a thiourea solution. The substrate is first placed in the pre-mixture, and the surface of the substrate is treated by the ammonia water in the pre-mixture. The substrate is heated inductively to a preset temperature, and then the thiourea solution is added, so that the reaction starts and CdS begin to deposit.

The above chemical bath deposition process is applied to the method for manufacturing the CIGS photovoltaic module. During manufacturing, the composite material layer is served as a protective layer for the opposite side of the substrate, so that this side of the substrate does not contact with the deposition solution and the substrate is uniformly heated; and that the CdS layer is deposited on the CIGS layer, which avoids an ineffective deposition of the CdS layer and the trouble of subsequent chemical cleaning.

The CIGS photovoltaic module manufactured as described above includes a substrate, a CIGS layer and a CdS layer stacked together, wherein the CdS layer uniformly and completely covers the CIGS layer surface to form a tight p-n junction interface, thereby ensuring a exciton separation efficiency (excitons are electron-hole pairs formed when electrons are not completely separated from nuclei, and electrons and holes in the electron-hole pairs are coupled in space by Coulomb interaction. A free electron and free hole are formed by a exciton separation, and the separated electron and hole are carriers of current, both of which may be called current carriers. The higher the separation efficiency of the exciton is, the higher the photoelectric conversion efficiency is, i.e. ensuring the photoelectric conversion rate. The CIGS photovoltaic module has the advantages of strong light absorption capability, high stability of power generation, high conversion efficiency, long power generation time during the day, high power generation, low production cost, short energy recovery period and the like. It can be applied not only to photovoltaic power plants, but also to building integrated photovoltaic (BIPV) or building attached photovoltaic (BAPV) (not integrated with building) and other fields. In addition, the flexible CIGS photovoltaic module can also be applied to portable power generation products, such as power generation paper and power generation backpacks.

Hereinafter, the method for manufacturing the CIGS photovoltaic module will be further illustrated by some examples.

### Example 1

Referring to Figs. 1 and 2, a glass substrate was selected as the substrate 1, and a CIGS layer 2 was plated on one side of the substrate 1.

Then, a composite material layer 3 was coated on the other side of the substrate 1 by screen printing; wherein the composite material 3 includes a cross-linked copolymer of polyacrylic resin and Fe₃O₄ particles mixed in the cross-linked copolymer of polyacrylic resin, and the cross-linked copolymer of polyacrylic resin and the Fe₃O₄ amount for 90% by mass and 10% by mass respectively.

Next, the substrate 1 on which the CIGS layer 2 and the composite material layer 3 have been formed was placed vertically and immersed into a reaction tank containing a pre-mixture of cadmium sulfate, ammonia water and pure water. Thereafter, an alternating current circuit was turned on, so that the reaction tank was in an alternating magnetic field 5 generated by the alternating current which has a frequency of 500 kHz. The alternating magnetic field 5 causes a large amount of eddy current to be generated in the composite material layer 3 containing Fe₃O₄ magnetic particles, the eddy current rapidly heated the composite material layer 3 and the substrate 1 was thus uniformly heated to 65°C. At this time, a thiourea solution was added, and CdS begun to deposit on the surface of the CIGS layer 2.

After the deposition is completed, the substrate 1 was turned to be horizontal, so that the side of the substrate with the composite material layer 3 on the surface was immersed in a DMSO solution 6 to make the cross-linked copolymer of polyacrylic resin to be dissolved and the Fe₃O₄ particles flow into the DMSO solution 6. By this way, the entire composite material layer 3 was separated from the substrate 1 to obtain a CIGS photovoltaic module including the substrate 1, the CIGS layer 2 and the CdS layer 4 stacked together, wherein the CdS layer 4 covered the surface of the CIGS layer 2 uniformly and completely.

By inspection, the light transmittance of the CdS layer 4 was improved, and the band gap (i.e. the minimum value of the energy that the bound electrons and holes must obtain to jump from the valence band to the conduction band and thus become free electrons or holes) was about 2.4 eV, so the CdS layer 4 was very suitable for serving as a buffer layer of a CIGS thin film solar cell.

### Example 2

Referring to Figs. 1 and 2, a glass substrate was selected as the substrate 1, and a CIGS layer 2 was plated on one side of the substrate 1.

Then, a composite material layer 3 was coated on the other side of the substrate 1 by screen printing; wherein the composite material layer 3 includes polyvinyl alcohol and Fe₃O₄ particles mixed in the polyvinyl alcohol, and the polyvinyl alcohol and Fe₃O₄ particles account for 80% by mass and 20% by mass respectively.

Next, the substrate 1 on which the CIGS layer 2 and the composite material layer 3 have been formed, was placed vertically and immersed into a reaction tank containing a pre-mixture of cadmium sulfate, ammonia water and pure water. Thereafter, an alternating current circuit was turned on, so that the reaction tank was in an alternating magnetic field 5 generated by the alternating current which has a frequency of 550 kHz. The alternating magnetic field 5 causes a large amount of eddy current to be generated in the composite material layer 3 containing Fe₃O₄ magnetic particles, the eddy current rapidly heated the composite material layer 3 and the substrate 1 was thus uniformly heated to 60°C. At this time, a thiourea solution was added, and CdS begun to deposit on the surface of the CIGS layer 2.

After the deposition is completed, the substrate 1 was turned to be horizontal, so that the side of the substrate with the composite material layer 3 on the surface was immersed in a DMF solution 6 to make the polyvinyl alcohol to be dissolved and the Fe₃O₄ particles flow into the DMF solution 6. By this way, the entire composite material layer 3 was separated from the substrate 1 to obtain a CIGS photovoltaic module including the substrate 1, the CIGS layer 2 and the CdS layer 4 stacked together, wherein the CdS layer 4 covered the surface of the CIGS layer 2 uniformly and completely.

By inspection, the light transmittance of the CdS layer 4 was improved, and the band gap was about 2.4 eV, so the CdS layer 4 was very suitable for serving as a buffer layer of a CIGS thin film solar cell.

### Example 3

Referring to Figs. 1 and 2, a glass substrate was selected as the substrate 1, and a CIGS layer 2 was plated on one side of the substrate 1.

Then, a composite material layer 3 was coated on the other side of the substrate 1 by screen printing; wherein the composite material layer 3 includes polyacrylamide and Fe₃O₄ particles mixed in the polyacrylamide, and the polyacrylamide and Fe₃O₄ particles account for 85% by mass and 15% by mass respectively.

Next, the substrate 1 on which the CIGS layer 2 and the composite material layer 3 have been formed, was placed vertically and immersed into a reaction tank containing a pre-mixture of cadmium sulfate, ammonia water and pure water. Thereafter, an alternating current circuit was turned on, so that the reaction tank was in an alternating magnetic field 5 generated by the alternating current which has a frequency of 500 kHz. The alternating magnetic field 5 causes a large amount of eddy current to be generated in the composite material layer 3 containing Fe₃O₄ magnetic particles, the eddy current rapidly heated the composite material layer 3 and the substrate 1 was thus uniformly heated to 68°C. At this time, a thiourea solution was added, and CdS begun to deposit on the surface of the CIGS layer 2.

After the deposition is completed, the substrate 1 was turned to be horizontal, so that the side of the substrate with the composite material layer 3 on the surface was immersed in a DMSO solution 6 to make the polyacrylamide to be dissolved and the Fe₃O₄ particles flow into the DMSO solution 6. By this way, the entire composite material layer 3 was separated from the substrate 1 to obtain a CIGS photovoltaic module including the substrate 1, the CIGS layer 2 and the CdS layer 4 stacked together, wherein the CdS layer 4 covered the surface of the CIGS layer 2 uniformly and completely.

By inspection, the light transmittance of the CdS layer 4 was improved, and the band gap was about 2.4 eV, so the CdS layer 4 was very suitable for serving as a buffer layer of a CIGS thin film solar cell.

### Example 4

Referring to Figs. 1 and 2, a glass substrate was selected as the substrate 1, and a CIGS layer 2 was plated on one side of the substrate 1.

Then, a composite material layer 3 was coated on the other side of the substrate 1 by screen printing; wherein the composite material layer 3 includes a silicon-based hydrogel and Fe₃O₄ particles mixed in the silicon-based hydrogel, and the silicon-based hydrogel and Fe₃O₄ particles account for 95% by mass and 5% by mass respectively.

Next, the substrate 1 on which the CIGS layer 2 and the composite material layer 3 have been formed, was placed vertically and immersed into a reaction tank containing a pre-mixture of cadmium sulfate, ammonia water and pure water. Thereafter, an alternating current circuit was turned on, so that the reaction tank was in an alternating magnetic field 5 generated by the alternating current which has a frequency of 450 kHz. The alternating magnetic field 5 causes a large amount of eddy current to be generated in the composite material layer 3 containing Fe₃O₄ magnetic particles, the eddy current rapidly heated the composite material layer 3 and the substrate 1 was thus uniformly heated to 70°C. At this time, a thiourea solution was added, and CdS begun to deposit on the surface of the CIGS layer 2.

After the deposition is completed, the substrate 1 was turned to be horizontal, so that the side of the substrate with the composite material layer 3 on the surface was immersed in a DMSO solution 6 to make the polyacrylamide to be dissolved and the Fe₃O₄ particles flow into the DMSO solution 6. By this way, the entire composite material layer 3 was separated from the substrate 1 to obtain a CIGS photovoltaic module including the substrate 1, the CIGS layer 2 and the CdS layer 4 stacked together, wherein the CdS layer 4 covered the surface of the CIGS layer 2 uniformly and completely.

By inspection, the light transmittance of the CdS layer 4 was improved, and the band gap was about 2.4 eV, so the CdS layer 4 was very suitable for serving as a buffer layer of a CIGS thin film solar cell.

### Example 5

Referring to Figs. 1 and 3, a glass substrate was selected as the substrate 1, and a CIGS layer 2 and a light-emitting layer 2' were plated on one side of the substrate 1.

Then, a composite material layer 3 was coated on the other side of the substrate 1 by screen printing; wherein the composite material layer 3 includes a cross-linked copolymer of polyacrylic resin and Fe₃O₄ particles mixed in the cross-linked copolymer of polyacrylic resin, and the cross-linked copolymer of polyacrylic resin and Fe₃O₄ particles account for 90% by mass and 10% by mass respectively.

Next, the substrate 1 on which the CIGS layer 2, the light-emitting layer 2' and the composite material layer 3 have been formed, was placed vertically and immersed into a reaction tank containing a pre-mixture of cadmium sulfate, ammonia water and pure water. Thereafter, an alternating current circuit was turned on, so that the reaction tank was in an alternating magnetic field 5 generated by the alternating current which has a frequency of 500 kHz. The alternating magnetic field 5 causes a large amount of eddy current to be generated in the composite material layer 3 containing Fe₃O₄ magnetic particles, the eddy current rapidly heated the composite material layer 3 and the substrate 1 was thus uniformly heated to 65°C. At this time, a thiourea solution was added, and CdS begun to deposit on the surface of the CIGS layer 2.

After the deposition is completed, the substrate 1 was turned to be horizontal, so that the side of the substrate with the composite material layer 3 on the surface was immersed in a DMSO solution 6 to make the polyacrylamide to be dissolved and the Fe₃O₄ particles flow into the DMSO solution 6. By this way, the entire composite material layer 3 was separated from the substrate 1 to obtain a CIGS photovoltaic module including the substrate 1, the CIGS layer 2, the light-emitting layer 2' and the CdS layer 4 stacked together, wherein the CdS layer 4 covered the surface of the CIGS layer 2 and the light-emitting layer 2' uniformly and completely.

By inspection, the light transmittance of the CdS layer 4 was improved, and the band gap (i.e. the minimum value of the energy that the bound electrons and holes must obtain to jump from the valence band to the conduction band and thus become free electrons or holes) was about 2.4 eV, so the CdS layer 4 was very suitable for serving as a buffer layer of a CIGS thin film solar cell.

Some embodiments of the present disclosure further provide a composite material. The composite material includes a polymeric hydrogel and magnetic nanoparticles mixed in the polymeric hydrogel.

In some embodiments of the present disclosure, the polymeric hydrogel accounts for 80% to 95% by mass and the magnetic nanoparticles accounts for 5% to 20% by mass based on the total mass of the composite material. The polymeric hydrogel is selected from at least one of the group consisting of cross-linked copolymer of polyacrylic resin, polyvinyl alcohol, polyacrylamide and silicon-based hydrogel. The magnetic nanoparticles are Fe₃O₄. The strength, swelling and other properties of the composite material can be controlled by those skilled in the art by using different polymeric hydrogel materials and magnetic nanoparticles according to specific working conditions, which is not limited in the present application.

In some embodiments, the composite material can be used as a coating material. For example, the composite material is used to cover the surface of the substrate as a protective film to protect the related surface of the substrate from external chemical reactions and the like. For another example, the composite material is used in a reaction under an electromagnetic induction condition, and the magnetic conductive material such as Fe₃O₄ magnetic particles in the composite material can generate heat under the action of electromagnetic induction after current is supplied, thereby elevating the temperature of the composite material. Moreover, the composite material can be dissolved into dimethyl sulfoxide (DMSO) or N-dimethyl formamide (DMF), or other similar solvent.

The technical features of the above-described embodiments may be combined arbitrarily. For the purpose of simplicity in description, all the possible combinations of the technical features in the above embodiments are not described. However, the combinations of these technical features shall fall within the scope of the specificationas long as they are not contradictory.

The foregoing embodiments only describe several implementations of the present disclosure, and their descriptions are specific and detailed, but cannot therefore be understood as a limitation to the patent scope of the present disclosure. It should be pointed out that a number of modifications and improvements may be made by those of ordinary skill in the art without departing from the conception of the present disclosure, and these all fall within the protection scope of the present disclosure. Therefore, the protection scope of the present disclosure shall be defined by the appended claims.

## Claims

1. A chemical bath deposition process, comprising the following steps:
forming a first functional layer on one side of a substrate, and forming a composite material layer including a polymeric hydrogel and magnetic nanoparticles mixed in the polymeric hydrogelon the opposite side of the substrate;
putting the substrate on which the first functional layer and the composite material layer have been formed, into a deposition solution to deposit a second functional layer on the first functional layer; and
separating the composite material layer from the substrate.

2. The chemical bath deposition method according to claim 1, wherein the first functional layer comprises a p-junction material layer.

3. The chemical bath deposition method according to claim 2, wherein the first functional layer further comprises a light-emitting layer, and the P-junction material layer and the light-emitting layer are disposed separately so as to make them insulative with each other.

4. The chemical bath deposition method according to claim 1, wherein the second functional layer comprises an n-junction material layer.

5. The chemical bath deposition method according to claim 1, wherein the polymeric hydrogel accounts for 80% to 95% by mass, and the magnetic nanoparticles accounts for 5% to 20% by mass of the composite material layer.

6. The chemical bath deposition method according to claim 1, wherein the polymeric hydrogel is selected from at least one of the group consisting of cross-linked copolymer of polyacrylic resin, polyvinyl alcohol, polyacrylamide and silicon-based hydrogel, and the magnetic nanoparticles are Fe₃O₄.

7. The chemical bath deposition method according to claim 1, wherein the substrate is heated inductively with an alternating magnetic field during depositing of the second functional layer.

8. The chemical bath deposition method according to claim 7, wherein the alternating magnetic field has a frequency of 450 kHz to 550 kHz.

9. The chemical bath deposition method according to claim 1, wherein the step of separating the composite material layer from the substrate comprises:
dissolving the composite material layer with a solvent; and
wherein the step of forming a composite material layer on the opposite side of the substrate comprises:
forming the composite material layer on the opposite side of the substrate by screen printing.

10. The chemical bath deposition method according to claim 9, wherein the solvent is selected from at least one of the group consisting of dimethyl sulfoxide and N-dimethyl formamide.

11. A method for manufacturing a CIGS photovoltaic module, comprising the following steps:
forming a CIGS layer on one side of a substrate, and forming a composite material layer including a polymeric hydrogel and magnetic nanoparticles mixed in the polymeric hydrogel on the opposite side of the substrate;
putting the substrate on which the CIGS layer and the composite material layer have been formed, into a deposition solution to deposit a CdS layer on the CIGS layer; and
separating the composite material layer from the substrate.

12. The method for manufacturing a CIGS photovoltaic module according to claim 11, wherein the polymeric hydrogel accounts for 80% to 95% by mass, and the magnetic nanoparticles accounts for 5% to 20% by mass of the composite material layer.

13. The method for manufacturing a CIGS photovoltaic module according to claim 11, wherein the step of depositing a CdS layer on the CIGS layer comprises:
heating inductively the substrate using an alternating magnetic field during depositing the CdS layer.

14. A composite material, comprising a polymeric hydrogel and magnetic nanoparticles mixed in the polymeric hydrogel.

15. The composite material according to claim 14, wherein the polymeric hydrogel accounts for 80% to 95% by mass, and the magnetic nanoparticles accounts for 5% to 20% by mass of the composite material layer,
the polymeric hydrogel is selected from at least one of the group consisting of cross-linked copolymer of polyacrylic resin, polyvinyl alcohol, polyacrylamide and silicon-based hydrogel, and
the magnetic nanoparticles are Fe₃O₄.
